# EUROPEAN PATENT SPECIFICATION

(11) **EP 3 332 419 B1**
(45) Date of publication and mention of the grant of the patent: **29.03.2023**
(21) Application number: 16751791.1
(22) Date of filing: 05.08.2016
(51) Int. Cl.: H01L 23/29, H01L 23/31, H01L 21/56, H01L 23/433

(54) **FLIP CHIP MODULE WITH ENHANCED PROPERTIES**
FLIP-CHIP-MODUL MIT VERBESSERTEN EIGENSCHAFTEN
MODULE DE PUCE RETOURNÉE À PROPRIÉTÉS AMÉLIORÉES

(30) Priority: 07.08.2015 US 201562202207 P; 10.08.2015 US 201562202967 P; 04.12.2015 US 201514959129
(43) Date of publication of application: 13.06.2018
(73) Proprietor: Qorvo US, Inc., Greensboro, NC 27409 (US)
(72) Inventor: COSTA, Julio C., Oak Ridge, North Carolina 27310 (US); MORRIS, Thomas Scott, Lewisville, North Carolina 27023 (US); HAMMOND, Jonathan Hale, Oak Ridge, North Carolina 27310 (US); JANDZINSKI, David, Summerfield, North Carolina 27358 (US); PARKER, Stephen, Burlington, North Carolina 27215 (US); CHADWICK, Jon, Greensboro, North Carolina 27408 (US)
(74) Representative: D Young & Co LLP
(86) International application number: PCT/US2016/045809
(87) International publication number: WO 2017/027389

(56) References cited:
- US-A1- 2008 315 372
- US-A1- 2014 327 150
- US-A1- 2016 100 489

## Description

### Field of the Disclosure

The present disclosure relates to a packaging process, and to a packaging process to enhance thermal performance of encapsulated flip chip dies.

### Background

With the current popularity of portable communication devices and developed semiconductor fabrication technology, high speed and high performance transistors are more densely integrated on semiconductor dies. Consequently, the amount of heat generated by the semiconductor dies will increase significantly due to the large number of transistors integrated on the semiconductor dies, the large amount of power passing through the transistors, and the high operation speed of the transistors. Accordingly, it is desirable to package the semiconductor dies in a configuration for better heat dissipation.

Flip chip assembly technology is widely utilized in semiconductor packaging due to its preferable solder interconnection between flip chip dies and laminate, which eliminates the space needed for wire bonding and die surface area of a package and essentially reduces the overall size of the package. In addition, the elimination of wire connections and implementation of a shorter electrical path from the flip chip die to the laminate reduces undesired inductance and capacitance.

In flip chip assembly, mold compounds, formulated from epoxy resins containing silica particulates, are used to encapsulate and underfill flip chip dies to protect the dies against damage from the outside environment. Some of the mold compounds can be used as a barrier withstanding chemistries such as potassium hydroxide (KOH), sodium hydroxide (NaOH), and acetylcholine (ACH) without breakdown; while some of the mold compounds having good thermal conductive features can be used for heat dissipation of dies.
US 2014/0327150 discloses a semiconductor device including a substrate including a first surface and a second surface opposite to each other, a through-via electrode extending through the substrate. The through-via electrode has an interconnection metal layer and a barrier metal layer surrounding a side surface of the interconnection metal layer. One end of the through-via electrode protrudes above the second surface. A spacer insulating layer may be provided on an outer sidewall of the through-via electrode. A through-via electrode pad is connected to the through-via electrode and extends on the spacer insulating layer substantially parallel to the second surface. US 2008/315372A1 relates to a `Wafer level integration package'. US 2016/100489A1 relates to a 'Method for manufacturing an integrated circuit package'. US 2016/100489A1 does not disclose, at least, the following features of claims 1 and 12: 'wherein the first mold compound includes a ferrite nanopowder to provide magnetic permeability, the second mold compound includes a filler to provide mechanical strength, and the third mold compound includes a thermally conductive additive to provide thermal conductance through the third mold compound'.

To accommodate the increased heat generation of high performance dies and to utilize the advantages of flip chip assembly, it is therefore an object of the present disclosure to provide a method to package flip chip dies in a configuration for better heat dissipation. In addition, there is also a need to enhance the thermal performance of encapsulated flip chip dies without increasing the package size.

### Summary

The invention is defined in the appended claims. According to the present invention, there is provided a flip chip module according to claim 1. In a second aspect, there is provided a method for fabricating a flip chip module according to claim 7.

Those skilled in the art will appreciate the scope of the disclosure and realize additional aspects thereof after reading the following detailed description in association with the accompanying drawings.

### Brief Description of the Drawings

The accompanying drawings incorporated in and forming a part of this specification illustrate several aspects of the disclosure, and together with the description serve to explain the principles of the disclosure.
Figure 1 provides a flow diagram that illustrates an etching and filling process according to one example of the present disclosure.
Figures 2 through 8 illustrate the steps associated with the etching and filling process provided in Figure 1.
Figure 9 illustrates an exemplary application of the present disclosure. The embodiments associated with figures 1 to 9 are provided for illustrative purposes only and do not fall within the scope of the claimed invention.
Figure 10A is a first section of a flow diagram that illustrates additional process steps that include a first mold compound used as an underfill and a second mold compound used as an encapsulate combined with a selective etching step that removes the substrates of selected flip chip dies.
Figure 10B is a second section for the flow diagram of Figure 10A, which illustrates disposing a dielectric layer and applying a third mold compound to fill cavities left by etching substrates of selected flip chip dies.
Figure 11 is a cross-section view of a flip chip module fabricated using the process provided in Figure 10A and Figure 10B.
Figure 12 is a specification table that lists thermal, mechanical, electrical, and physical specifications for an exemplary polymer material that is usable as a mold compound that is in accordance with the present disclosure.

### Detailed Description

The embodiments set forth below represent the necessary information to enable those skilled in the art to practice the disclosure and illustrate the best mode of practicing the disclosure. Upon reading the following description in light of the accompanying drawings, those skilled in the art will understand the concepts of the disclosure and will recognize applications of these concepts not particularly addressed herein. It should be understood that these concepts and applications fall within the scope of the disclosure and the accompanying claims.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. Likewise, it will be understood that when an element such as a layer, region, or substrate is referred to as being "over" or extending "over" another element, it can be directly over or extend directly over the other element or intervening elements may also be present. In contrast, when an element is referred to as being "directly over" or extending "directly over" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "vertical" may be used herein to describe a relationship of one element, layer, or region to another element, layer, or region as illustrated in the Figures. It will be understood that these terms and those discussed above are intended to encompass different orientations of the device in addition to the orientation depicted in the Figures.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

Both thermoset polymers and thermoplastic polymers are disclosed as mold compounds in this disclosure. Thermoset polymers cross-link together to form an irreversible chemical bond. As such, thermoset polymers cannot be melted and re-molded after curing. A benefit of thermoset polymers is that they provide relatively high levels of dimensional stability in comparison to thermoplastic polymers. Dimensional stability is desirable for encapsulating interconnections between a flip chip die and a carrier.

In contrast, thermoplastic polymers soften when heated and become more fluid when heated past a plasticization temperature. Once cooled below the plasticization temperature, thermoplastic polymers can be reheated to be re-molded as no chemical bonding takes place like that of thermoset polymers. A benefit of thermoplastic polymers is chemical resistance. Another benefit is that additives such as carbon particles and other fillers are usable to provide thermoset polymers with various physical properties. Such fillers are readily mixed with thermoplastic polymers because there are no chemical bonds to interfere with. However, it is to be understood that thermoset polymers can also accommodate some additives and fillers with particular care being taken with regard to ratios and types of additives in comparison to thermoplastic polymers.

For the purpose of this disclosure a thinned flip chip die, also referred to as an etched flip chip die, is one with at least 95% of a semiconductor substrate removed by chemical etching, mechanical grinding, or a combination of chemical etching and mechanical grinding, or peeling. In contrast, a flip chip die with an intact semiconductor substrate is one that has not undergone a substrate removal process. However, it is to be understood that some etching of a semiconductor substrate to provide via holes and patterning can occur and the semiconductor substrate would still be considered an intact semiconductor substrate as long as 95% of an original substrate remains after etching.

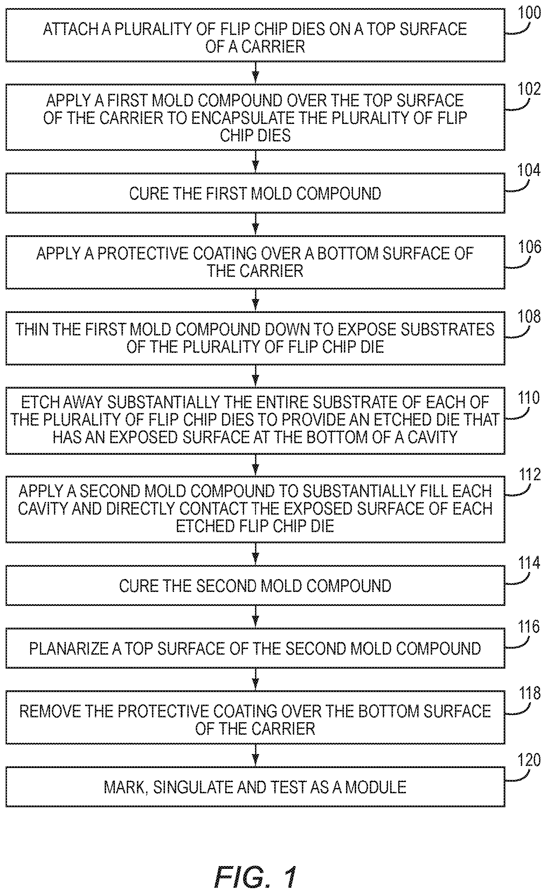

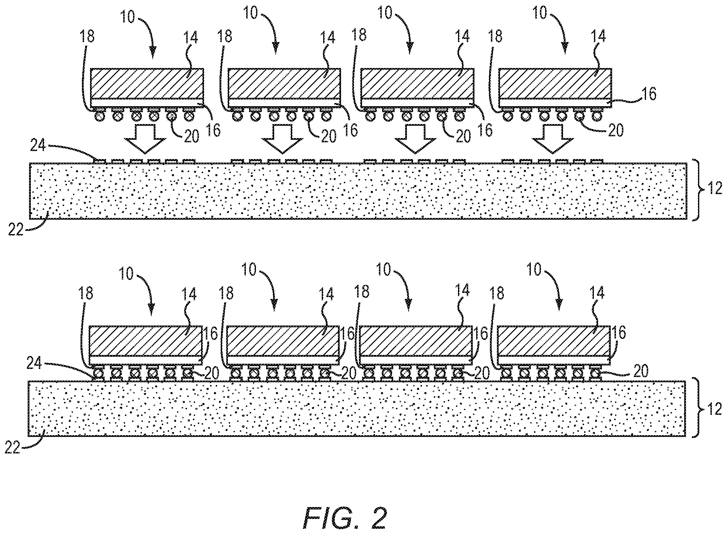

The present disclosure relates to a method to enhance the thermal performance of encapsulated flip chip dies. Figure 1 provides a flow diagram that illustrates an etching and filling process according to one embodiment of the present disclosure which does not fall within the claimed invention. Figures 2-8 illustrate the steps associated with the etching and filling process provided in Figure 1. Although various types of materials may be used for the substrate, the following examples incorporate silicon as the preferred material. Initially, a plurality of flip chip dies 10 are attached on a top surface of a carrier 12 as depicted in Figure 2 (Step 100). The carrier of the described embodiment is formed from a laminate, but may also be formed from a wafer level fan out (WLFO) carrier, a lead frame, a ceramic carrier, or the like. For the purpose of this illustration, each flip chip die 10 includes a substrate 14 with approximately 150-500 µm thickness, a device layer 16 with approximately 4-7 µm thickness, layer contacts 18 located on a bottom surface of the device layer 16, and solder interconnections 20 provided on each of the layer contacts 18. The device layer 16 may be formed from silicon dioxide, gallium arsenide, gallium nitride, silicon germanium, and the like and includes various devices, such as diodes, transistors, mechanical switches, resonators, and the like. The carrier 12 includes a carrier body 22, carrier contacts 24 on a top surface of the carrier 12 and input/output (I/O) pads (not shown) on a bottom surface of the carrier 12. The I/O pads on the bottom surface of the carrier 12 may be formed by a ball grid array (BGA) or land grid array (LGA) method and selectively connect to the carrier contacts 24 through any number of vias (not shown).The solder interconnections 20 of the flip chip dies 10 are used to electrically and physically connect to the carrier contacts 24 of the carrier 12. As such, the backside of the substrate 14 of the plurality of flip chip dies 10 will generally be the tallest component after the attaching process. The height between the device layer 16 and the carrier body 22 often varies from 15-200 µm.

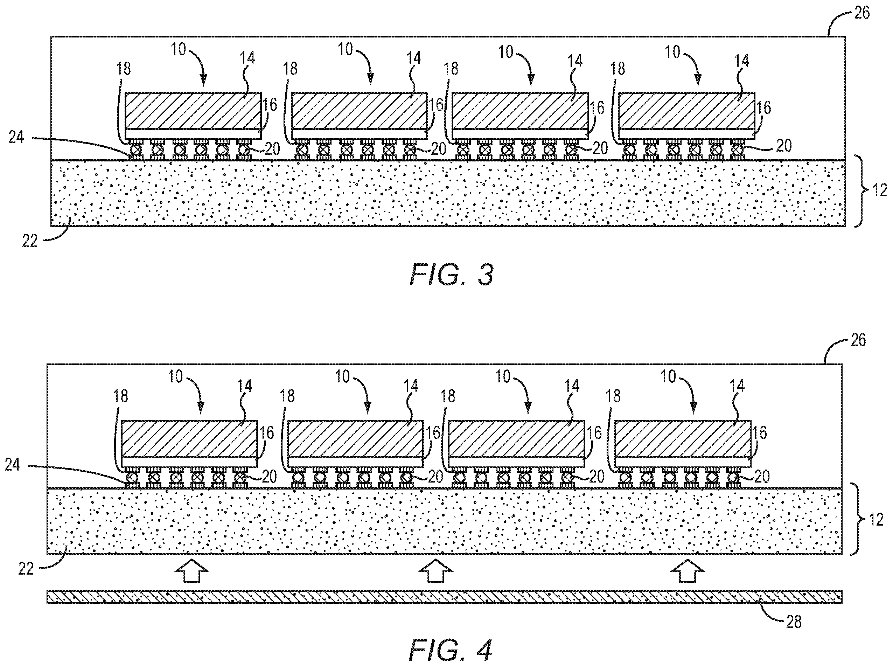

A first mold compound 26 is then applied over the top surface of the carrier 12 such that the flip chip dies 10 are encapsulated by the first mold compound 26 as illustrated in Figure 3 (Step 102). The first mold compound 26 may be applied by various procedures, such as sheet molding, overmolding, compression molding, transfer molding, dam fill encapsulation and screen print encapsulation. The first mold compound 26 is an organic epoxy resin system or the like, such as Hitachi Chemical Electronic Materials GE-100LFC, which can be used as an etchant barrier to protect the flip chip dies 10 against etching chemistries such as KOH, NaOH and ACH. A curing process (Step 104) is then used to harden the first mold compound.

With reference to Figures 4 through 6, a process for etching away substantially the entire substrate 14 of each encapsulated flip chip die 10 is provided according to one example of the present disclosure. The process begins by forming a protective coating 28 over the bottom surface of the carrier 12, as shown in Figure 4 (Step 106). The purpose of the protective coating 28 is to prevent potential damage to the I/O pads (not shown) on the bottom surface of the carrier 12 in subsequent processing steps. The protective coating 28 may be a chemical resistant tape or liquid protective coating, which can withstand etching chemistries such as KOH, NaOH and ACH without breakdown. Alternatively, a rigid carrier can be sealed on the bottom surface of the carrier 12 as a protective coating 28 to prevent the I/O pads (not shown) on the bottom surface of the carrier 12 from contacting the destructive etchant materials in later etching processes.

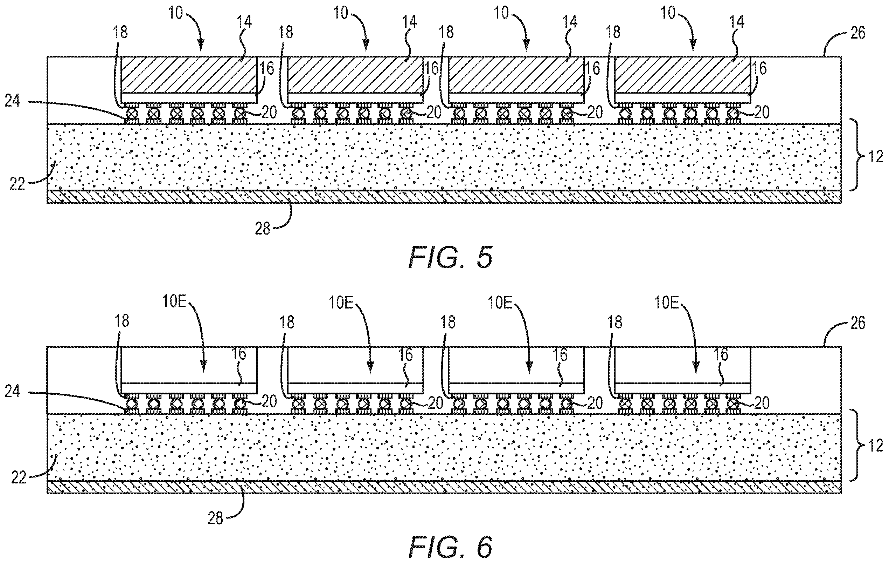

The next process step is to thin the first mold compound 26 down to expose the back side of the flip chip dies 10, wherein the only exposed component of the flip chip dies 10 will be the substrate 14, as shown in Figure 5 (Step 108). The thinning procedure may be done with a mechanical process. An alternative process step would be to leave the back side of the flip chip dies 10 always exposed during the molding process with the first mold compound 26.

Next, a wet/dry etchant chemistry, which may be KOH, ACH, NaOH or the like, is used to etch away substantially the entire substrate 14 of each flip chip die 10 to provide an etched flip chip die 10E that has an exposed surface at the bottom of a cavity, as shown in Figure 6 (Step 110). Herein, etching away substantially the entire substrate 14 refers to removal of at least 95% of the entire substrate 14, and perhaps a portion of the device layer 16. As such, in some applications, there is a thin layer of the substrate 14 left at the bottom of the cavity of each etched flip chip die 10E, which covers the device layer 16, to protect the devices located on the device layer 16. For other cases, the substrate 14 is etched away completely and the device layer 16 is exposed at the bottom of the cavity of each etched flip chip die 10E.

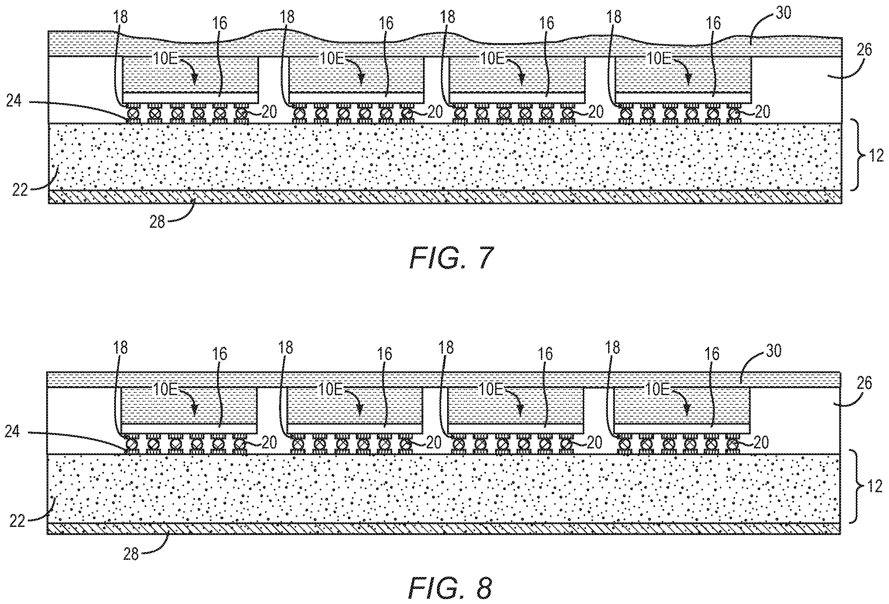

With reference to Figures 7 through 8, a process for filling the remaining cavity of each etched flip chip die 10E is provided according to one embodiment of the present disclosure. After the etching step is done, a second mold compound 30 is applied to substantially fill the remaining cavity of each etched flip chip die 10E, as illustrated in Figure 7 (Step 112). The second mold compound 30 may be applied by various procedures, such as sheet molding, overmolding, compression molding, transfer molding, dam fill encapsulation, and screen print encapsulation. The second mold compound 30 is a high thermal conductivity mold compound. Compared to the normal mold compound having 1 Watts per meter Kelvin (W/m·K) thermal conductivity, a high thermal conductivity mold compound has 2.5 W/m·K ~10 W/m·K or greater thermal conductivity, such as Hitachi Chemical Electronic Materials GE-506HT. The higher the thermal conductivity, the better the heat dissipation performance of the encapsulated etched flip chip dies 10E. Additionally, the second mold compound 30 directly contacts the exposed surface of each etched flip chip die 10E at the bottom of each cavity. If the substrate 14 is removed completely in the etching step (Step 110), the second mold compound 30 directly contacts the device layer 16. If there is a thin layer of substrate 14 left in the etching step (Step 110), the second mold compound 30 directly contacts the thin layer of substrate 14. Notably, the first mold compound 26 could be formed from the same material as the second mold compound 30. However, unlike the second mold compound 30, the first mold compound 26 does not have a thermal conductivity requirement in higher performing embodiments. A curing process (Step 114) is then provided to harden the second mold compound. The normal curing temperature is 175 ºF and could be higher or lower depending on which material is used as the second mold compound 30.

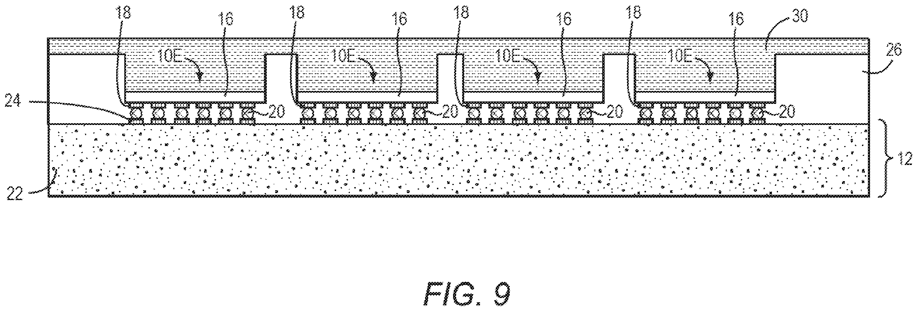

The top surface of the second mold compound 30 is then planarized to ensure each encapsulated etched flip chip die 10E has a flat top surface as shown in Figure 8 (Step 116). A package grinding process may be used for planarization. Next, the protective coating 28 applied over the bottom surface of the carrier 12 is removed as illustrated in Figure 9 (Step 118). Lastly, the product could be marked, singulated and tested as a module (Step 120).

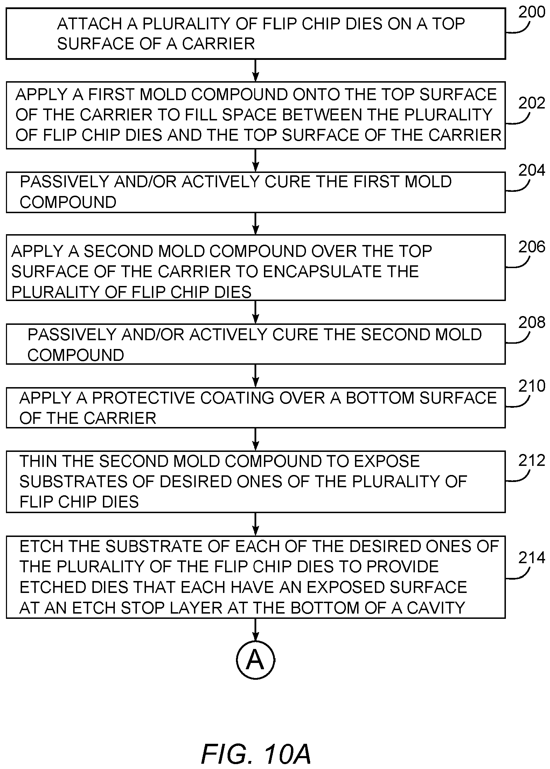

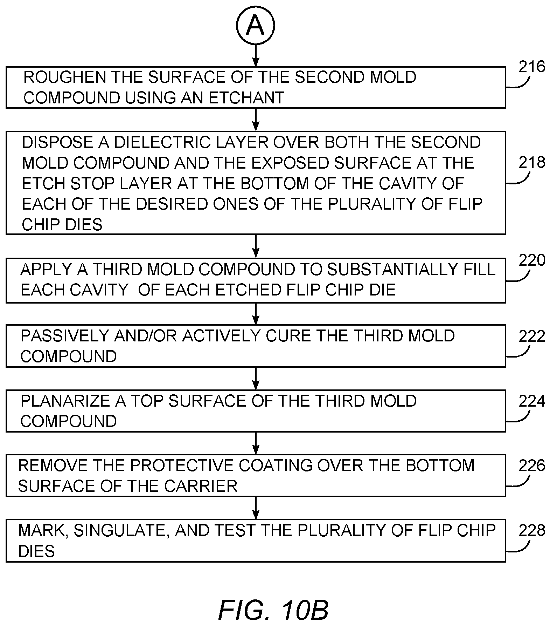

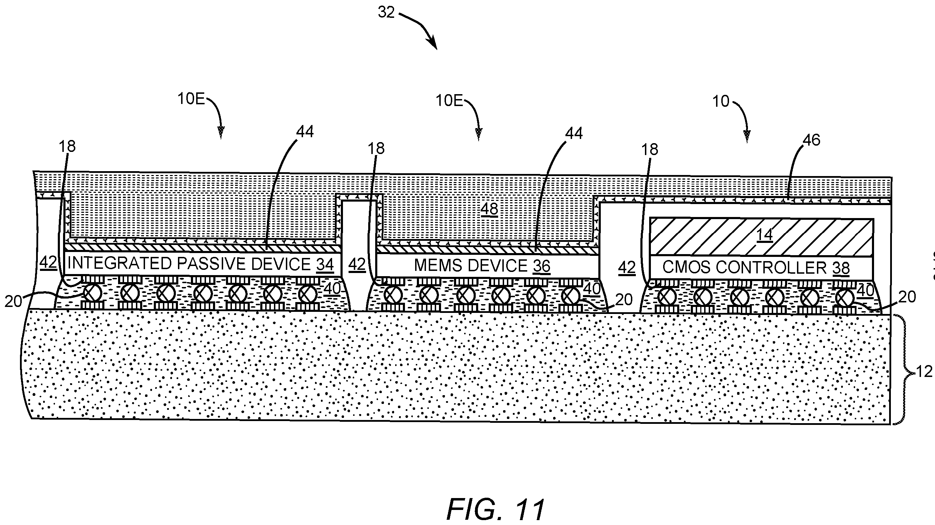

Figure 10A and Figure 10B make up a flow diagram that illustrates process steps for fabricating the claimed invention. Figure 11 is a cross-section view of the invention that is a flip chip module 32, which is fabricated using the process provided in Figure 10A and Figure 10B. Viewing Figure 10A in conjunction with Figure 11, initially, a plurality of flip chip dies 10 are attached onto a top surface of the carrier 12 (Step 200). In the exemplary embodiment shown in Figure 11, the leftmost flip chip die 10 includes an integrated passive device (IPD) 34, the middle flip chip die 10 includes a microelectromechanical systems (MEMS) device 36, and the rightmost flip chip die 10 includes a complementary metal oxide semiconductor (CMOS) controller 38. The IPD 34 typically comprises passive components such as integrated inductors, capacitors, and resistors. The MEMS device 36 is typically an RF switch that is controlled by the CMOS controller 38. The solder interconnections 20 of the flip chip dies 10 are used to electrically and physically connect to the carrier contacts 24 of the carrier 12. It is to be understood that the MEMS device 36 comprises mechanical parts that move within a cavity under a lid. For example, a MEMS RF switch version of MEMS device 36 includes a cantilever having a first end attached to an anchor and a second end situated over a conductive pad. An actuator plate beneath the cantilever is charged to attract the second end of the cantilever to make contact with the conductive pad to provide a low resistance electrical path between the anchor and the conductive pad. In other words, charging the actuator plate closes the MEMS RF switch. Discharging the actuator plate allows the second end of the cantilever to spring away from the conductive pad, thereby opening the MEMS RF switch and providing nearly infinite resistance to electrical current flow. Other types of MEMS devices such as MEMS capacitors are also envisioned as MEMS device 36. Such MEMS devices are well known to those skilled in the art, and are within the scope of this disclosure.

Next, a first mold compound 40 is applied to portions of the top surface of the carrier 12 substantially near each of the plurality of flip chip dies 10 to fill space between the plurality of flip chip dies 10 and the top surface of the carrier 12 (Step 202). The first mold compound 40 is an epoxy resin that has an uncured viscosity of no more than 360 mPa·s when measured with a cone and plate viscometer. This relatively low viscosity in comparison to encapsulating epoxy resins allows the first mold compound 40 to wick between and around the solder interconnections 20 by capillary action. As such, the first mold compound 40 is known in industry as a capillary underfill designed to cure in about eight minutes at 130°C and about five minutes at 150°C to minimize stress on the solder interconnections 20. In one embodiment, the first mold compound has a glass transition temperature of 113°C with a coefficient of thermal expansion of 55 parts per million per °C (ppm/°C) below the glass transition temperature of 113°C. An exemplary material for the first mold compound 40 is made by Henkel and is marketed under the product number UF3808.

In the claimed invention, the first mold compound 40 includes an additive powder to increase magnetic permeability. Suitable additive powders include fully sintered nickel zinc (Ni-Zn) ferrite, magnesium zinc (Mg-Zn), and manganese (Mn-Zn) nanopowders having magnetic saturations between 45 and 80 electromagnetic units per gram (emu/g).

The first mold compound 40 is either actively or passively cured (Step 204). Actively curing the first mold compound 40 is accomplished by exposing the first mold compound 40 to energy such as heat energy, light energy, or chemical energy, depending on the material making up the first mold compound 40. Examples of adding energy to cure the first mold compound 40 include heating the first mold compound 40 to a predetermined elevated temperature such as 175 °F, exposing the first mold compound 40 to ultraviolet (UV) light, or exposing the first mold compound 40 to an activating chemical vapor or spray. Passively curing the first mold compound 40 would allow the first mold compound 40 to cure over time without intervention. The first mold compound 40 can include additives that enhance thermal properties such as thermal conductivity, electrical properties such as permittivity, and/or magnetic properties such as permeability. The first mold compound includes a ferrite nanopowder to provide magnetic permeability.

Once the first mold compound 40 is cured, a second mold compound 42 is applied over the top surface of the carrier 12 to encapsulate the plurality of flip chip dies 10 (Step 206). The second mold compound 42 is then passively and/or actively cured (Step 208). Actively curing the second mold compound 42 is accomplished by exposing the second mold compound 42 to energy such as heat energy, light energy, or chemical energy depending on the material making up the second mold compound 42. Passively curing the second mold compound 42 would allow the second mold compound 42 to cure over time without intervention. The second mold compound 42 can include additives that enhance thermal properties such as thermal conductivity, electrical properties such as permittivity, and/or magnetic properties such as permeability. However, it is to be understood that the second mold compound 42 does not necessarily include the same additives or the same amount of additives that may be present in the first mold compound 40. Moreover, the second mold compound 42 is not the same material as the first mold compound 40. Therefore, the second mold compound 42 may or may not be cured the same way as the first mold compound 40. An exemplary material making up the second mold compound 42 is a biphenyl thermoset epoxy manufactured by Hitachi and marketed under the product number GE100-LFCS. In at least one embodiment not according to the invention, the second mold compound 42 and the first mold compound 40 are one in the same. For example, in at least one embodiment not according to the invention, the biphenyl thermoset epoxy would make up both the first mold compound 40 and the second mold compound 42. The second mold compound includes a filler to provide mechanical strength.

The process continues by forming the protective coating 28 (as shown in Figures 4 through 8) over the bottom surface of the carrier 12 (Step 210). The purpose of the protective coating 28 is to prevent potential damage to the I/O pads (not shown) on the bottom surface of the carrier 12 in subsequent processing steps. The protective coating 28 may be a chemical resistant tape or liquid protective coating, which can withstand etching chemistries such as KOH, NaOH, and ACH without breakdown. Alternatively, a rigid carrier can be sealed on the bottom surface of the carrier 12 as a protective coating 28 to prevent the I/O pads (not shown) on the bottom surface of the carrier 12 from contacting the destructive etchant materials in later etching processes.

The next process step is to thin the first mold compound 40 down to expose the back side of select ones of the plurality of flip chip dies 10, wherein the only exposed component of the flip chip dies 10 will be the substrate 14 (Step 212). As depicted in Figure 11, the substrate 14 of the rightmost one of the flip chip dies 10 having the CMOS controller 38, is not exposed because it is lower in height than either of the other ones of the plurality of flip chip dies 10 depicted in Figure 11. In this exemplary embodiment of the invention, the leftmost one and the middle one of the plurality of the flip chip dies 10 have the substrate 14 removed. The thinning procedure may be done with a mechanical process. An alternative process step would be to leave the back side of the desired ones of the plurality of flip chip dies 10 always exposed during the molding process that applies the second mold compound 42.

Each of the substrates 14 exposed in the previous step are then etched to provide etched dies 10E that each have an exposed surface at an etch stop layer 44 that is disposed over each of the IPD 34 and the MEMS device 36 (Step 214). Once an etchant reaches the etch stop layer 44, the etch process inherently stops due to the chemical composition of the etch stop layer 44. The etch stop layer 44 is typically a dielectric layer such as a buried oxide (BOX) layer. The etch stop layer 44 is not needed and therefore not disposed over the CMOS controller 38.

Turning now to Figure 10B while keeping Figure 11 in view, the process continues by using an etchant to roughen the surface of the second mold compound 42 (Step 216). An exemplary way to achieve the roughening produced in this step is to employ a wet chemistry etchant such as potassium hydroxide and water (KOH:H₂O), which causes surface silica spheres that are typically present in the second mold compound 42 to dissolve leaving a pitted surface. The now pitted surface of the second mold compound 42 provides a substantial enhancement in adhesion of a subsequently applied or disposed material.

Next, a dielectric layer 46 is disposed over both the second mold compound 42 and the exposed surface at the etch stop layer 44 at the bottom of a cavity left by etching the substrate 14 of each of the etched flip chip dies 10E (Step 218). The dielectric layer 46 provides a moisture barrier that is not provided by the etch stop layer 44. An exemplary material making up etch stop layer 44 is silicon nitride SiN. The dielectric layer 46 can be between 200 Å to 5000 Å thick and is typically between 1000 Å and 2000 Å thick.

The process continues by applying a third mold compound 48 to substantially fill each cavity and directly contact the exposed surface of each of the etched ones of the plurality of flip chip dies 10 (Step 220). In this exemplary embodiment, the exposed surface is the exposed surface of the dielectric layer 46. Also, as shown in the exemplary embodiment of Figure 11, the third mold compound 48 can be disposed over the entirety of the dielectric layer 46.

The third mold compound 48 is then passively and/or actively cured (Step 222). Actively curing the third mold compound 48 is accomplished by exposing the third mold compound 48 to energy such as heat energy, light energy, or chemical energy depending on the material making up the third mold compound 48. Passively curing the third mold compound 48 would allow the third mold compound 48 to cure over time without intervention. The third mold compound 48 can include additives that enhance thermal properties such as thermal conductivity, electrical properties such as permittivity, and/or magnetic properties such as permeability. The third mold compound includes a thermally conductive additive to provide thermal conductance through the third mold compound. However, it is to be understood that the third mold compound 48 does not necessarily include the same additives or the same amount of additives that may be present in either the first mold compound 40 or the second mold compound 42. Moreover, the third mold compound 48 is not the same material as either the first mold compound 40 or the second mold compound 42. Therefore, the third mold compound 48 may or may not be cured the same way as either the first mold compound 40 or the second mold compound 42.

Once the third mold compound 48 is cured, a top surface of the third mold compound 48 is planarized to ensure that each encapsulated etched flip chip die 10E has a flat top surface as shown in Figure 11 (Step 224). A package grinding process may be used for planarization. Next, the protective coating 28 applied over the bottom surface of the carrier 12 is removed as illustrated in Figure 9 (Step 226). Lastly, the flip chip module 32 is marked, singulated and tested (Step 228).

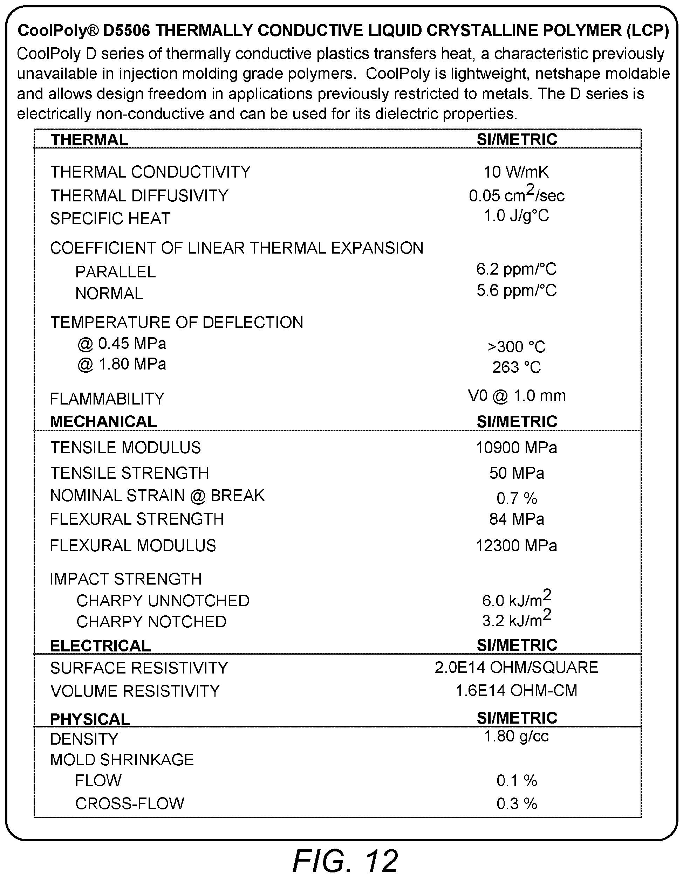

Figure 12 is a specification table that lists thermal, mechanical, electrical, and physical specifications for an exemplary polymer material that is usable as a mold compound that is in accordance with the present disclosure. In at least one embodiment, this exemplary polymer material is a thermoplastic that is usable as the third mold compound. Moreover, in at least one embodiment not according to the invention, the second mold compound and the third mold compound are one in the same and comprise this exemplary polymer material.

The exemplary polymer material specified in the specification table of Figure 12 is made by Cool Polymers^{®} and is sold under the label "CoolPoly^{®} D5506 Thermally Conductive Liquid Crystalline Polymer (LCP)." It is to be understood that the specification table of Figure 12 only provides exemplary specifications and that a variety of mechanical and physical properties are available within the scope of the present disclosure. Moreover, the quantitative values for the thermal and electrical properties provided in the table of Figure 12 only represent exemplary values that are within the range of thermal and electrical properties already discussed in the above disclosure.

## Claims

1. A flip chip module comprising:
• a carrier (12) having a top surface;
• a first mold compound (40) residing on the top surface;
• a first thinned flip chip die (34, 36) with no semiconductor substrate and residing over a first portion of the first mold compound and having a first set of interconnects (18, 20, 24) extending from the device layer (16) and through the first portion of the first mold compound to the top surface wherein the first portion of the first mold compound fills a region between the first thinned flip chip die and the top surface, wherein the first thinned flip chip die provides an integrated passive device, IPD, or a microelectromechanical, MEMS, component;
• a second mold compound (42) residing over the carrier and in contact with the first mold compound and providing a first cavity over the first thinned flip chip die wherein the first cavity extends to a first die surface of the first thinned flip chip die, wherein the first die surface is an etch stop layer;
• a third mold compound (48) residing in the first cavity and covering the etch stop layer of the first thinned flip chip die, wherein the first mold compound, and the second mold compound, and the third mold compound are not the same with each having different physical properties, wherein the first mold compound includes a ferrite nanopowder to provide magnetic permeability, the second mold compound includes a filler to provide mechanical strength, and the third mold compound includes a thermally conductive additive to provide thermal conductance through the third mold compound; and
• a second thinned flip chip die (34, 36) having no semiconductor substrate and residing over a second portion of the first mold compound and having a second set of interconnects extending through the second portion to the top surface wherein:
• the second portion of the first mold compound fills a region between the second thinned flip chip die and the top surface;
• the second mold compound provides a second cavity over the second flip chip die such that the second cavity extends to a second die surface of the second thinned flip chip die, wherein the second die surface is a second etch stop layer; and
• the third mold compound resides in the second cavity and covers the second die surface of the second thinned flip chip die, and wherein the second flip chip die provides the other of the IPD or MEMS component.

2. The flip chip module of claim 1 further comprising a further flip chip die (38) having a semiconductor substrate (14), the further flip chip die residing over a second portion of the first mold compound and having a second set of interconnects extending through the first portion to the top surface wherein:
• the second portion of the first mold compound fills a region between the further flip chip die and the top surface;
• the second mold compound covers the semiconductor substrate of the further flip chip die; and
• the third mold compound covers a surface of the second mold compound.

3. The flip chip module of claim 2 wherein the first thinned flip chip die is a MEMS device and the further flip chip die is a complementary metal oxide semiconductor, CMOS, controller.

4. The flip chip module of claim 1 wherein the second mold compound has a surface configured to promote adhesion with the third mold compound.

5. The flip chip module of claim 1 wherein the etch stop layer (44) comprises buried oxide, BOX.

6. The flip chip module of claim 1 wherein the third mold compound has a thermal conductivity greater than 2.5 W/m-K and an electrical resistivity greater than 10³ Ohm-cm.

7. A method for fabricating a flip chip module comprising:
• providing a carrier having a top surface;
• attaching (200) a flip chip die to the top surface of the carrier by way of interconnects (18, 20, 24) that extend from the flip chip die to the top surface of the carrier, wherein the first flip chip die provides an integrated passive device, IPD, or a microelectromechanical, MEMS, component;
• filling (202) space between the flip chip die and the top surface of the carrier with a first mold compound;
• applying (206) a second mold compound onto the top surface of the carrier to encapsulate the flip chip die;
• thinning the second mold compound to expose a substrate of the flip chip die;
• etching away the substrate of the flip chip die such that none of the substrate remains to provide a thinned flip chip die having an exposed surface at the bottom of a cavity, wherein the exposed surface at the bottom of the cavity is a surface of an etch stop layer; and
• applying (220) a third mold compound to substantially fill the cavity of the thinned flip chip die, wherein the first mold compound, and the second mold compound, and the third mold compound are not the same with each having different physical properties, wherein the first mold compound includes a ferrite nanopowder to provide magnetic permeability, the second mold compound includes a filler to provide mechanical strength, and the third mold compound includes a thermally conductive additive to provide thermal conductance through the third mold compound.

8. The method for fabricating the flip chip module of claim 7 further including disposing (218) a dielectric layer over the exposed surface at the etch stop layer (44) at the bottom of the cavity before applying the third mold compound.

9. The method for fabricating the flip chip module of claim 8 wherein the etch stop layer is made of BOX and the dielectric layer is made of SiN.

10. The method for fabricating the flip chip module of claim 7 further including roughening (216) a top surface of the second mold compound before applying the third mold compound.

## Patentansprüche

1. Flip-Chip-Modul, Folgendes umfassend:
• einen Träger (12) mit einer oberen Oberfläche;
• eine erste Formmasse (40), die sich auf der oberen Oberfläche befindet;
• ein erstes verschwächtes Flip-Chip-Plättchen (34, 36) ohne Halbleitersubstrat, und das sich über einem ersten Abschnitt der ersten Formmasse befindet und einen ersten Satz von Verbindungswegen (18, 20, 24) aufweist, die sich aus der Vorrichtungsschicht (16) und durch den ersten Abschnitt der ersten Formmasse an die obere Oberfläche erstrecken, wobei der erste Abschnitt der ersten Formmasse einen Bereich zwischen dem ersten verschwächten Flip-Chip-Plättchen und der oberen Oberfläche füllt, wobei das erste verschwächte Flip-Chip-Plättchen eine integrierte passive Vorrichtung, IPD, oder eine mikroelektromechanische, MEMS, Komponente bereitstellt;
• eine zweite Formmasse (42), die sich über dem Träger und in Kontakt mit der ersten Formmasse befindet und einen ersten Hohlraum über dem ersten verschwächten Flip-Chip-Plättchen bereitstellt, wobei sich der erste Hohlraum an eine erste Plättchenoberfläche des ersten verschwächten Flip-Chip-Plättchens erstreckt, wobei die erste Plättchenoberfläche eine Ätzstoppschicht ist;
• eine dritte Formmasse (48), die sich in dem ersten Hohlraum befindet und die Ätzstoppschicht des ersten verschwächten Flip-Chip-Plättchens bedeckt, wobei die erste Formmasse und die zweite Formmasse und die dritte Formmasse nicht die gleichen sind, wobei jede verschiedene physikalische Eigenschaften aufweist, wobei die erste Formmasse ein Ferrit-Nanopulver umfasst, um eine magnetische Permeabilität bereitzustellen, die zweite Formmasse ein Füllmittel umfasst, um eine mechanische Festigkeit bereitzustellen, und die dritte Formmasse einen wärmeleitenden Zusatzstoff umfasst, um eine thermische Leitfähigkeit durch die dritte Formmasse bereitzustellen; und
• ein zweites verschwächtes Flip-Chip-Plättchen (34, 36) ohne Halbleitersubstrat, und das sich über einem zweiten Abschnitt der ersten Formmasse befindet und einen zweiten Satz von Verbindungswegen aufweist, die sich durch den zweiten Abschnitt an die obere Oberfläche erstrecken, wobei:
• der zweite Abschnitt der ersten Formmasse einen Bereich zwischen dem zweiten verschwächten Flip-Chip-Plättchen und der oberen Oberfläche füllt;
• die zweite Formmasse einen zweiten Hohlraum über dem zweiten Flip-Chip-Plättchen bereitstellt, so dass sich der zweite Hohlraum zu einer zweiten Plättchenoberfläche des zweiten verschwächten Flip-Chip-Plättchens erstreckt, wobei die zweite Plättchenoberfläche eine zweite Ätzstoppschicht ist; und
• die dritte Formmasse sich in dem zweiten Hohlraum befindet und die zweite Plättchenoberfläche des zweiten verschwächten Flip-Chip-Plättchens bedeckt, und wobei das zweite Flip-Chip-Plättchen die andere Komponente der IPD oder der MEMS bereitstellt.

2. Flip-Chip-Modul nach Anspruch 1, weiterhin umfassend ein weiteres Flip-Chip-Plättchen (38) mit einem Halbleitersubstrat (14), wobei sich das weitere Flip-Chip-Plättchen über einem zweiten Abschnitt der ersten Formmasse befindet und einen zweiten Satz von Verbindungswegen aufweist, die sich durch den ersten Abschnitt an die obere Oberfläche erstrecken, wobei:
• der zweite Abschnitt der ersten Formmasse einen Bereich zwischen dem weiteren Flip-Chip-Plättchen und der oberen Oberfläche füllt;
• die zweite Formmasse das Halbleitersubstrat des weiteren Flip-Chip-Plättchens bedeckt; und
• die dritte Formmasse eine Oberfläche der zweiten Formmasse bedeckt.

3. Flip-Chip-Modul nach Anspruch 2, wobei das erste verschwächte Flip-Chip-Plättchen eine MEMS-Vorrichtung ist und das weitere Flip-Chip-Plättchen eine komplementäre Metalloxidhalbleiter-, CMOS-, Steuervorrichtung ist.

4. Flip-Chip-Modul nach Anspruch 1, wobei die zweite Formmasse eine Oberfläche aufweist, die eingerichtet ist, um eine Anhaftung an der dritten Formmasse zu fördern.

5. Flip-Chip-Modul nach Anspruch 1, wobei die Ätzstoppschicht (44) vergrabenes Oxid, BOX, umfasst.

6. Flip-Chip-Modul nach Anspruch 1, wobei die dritte Formmasse eine Wärmeleitfähigkeit größer als 2,5 W/m•K und einen spezifischen elektrischen Widerstand größer als 10³ Ohm/cm aufweist.

7. Verfahren zum Herstellen eines Flip-Chip-Moduls, Folgendes umfassend:
• Bereitstellen eines Trägers mit einer oberen Oberfläche;
• Befestigen (200) eines Flip-Chip-Plättchens an der oberen Oberfläche des Trägers durch Verbindungswege (18, 20, 24), die sich von dem Flip-Chip-Plättchen an die obere Oberfläche des Trägers erstrecken, wobei das erste Flip-Chip-Plättchen eine integrierte passive Vorrichtung, IPD, oder eine mikroelektromechanische, MEMS, Komponente bereitstellt;
• Füllen (202) des Raums zwischen dem Flip-Chip-Plättchen und der oberen Oberfläche des Trägers mit einer ersten Formmasse;
• Aufbringen (206) einer zweiten Formmasse auf der oberen Oberfläche des Trägers, um das Flip-Chip-Plättchen zu verkapseln;
• Verschwächen der zweiten Formmasse, um ein Substrat des Flip-Chip-Plättchens freizulegen;
• Wegätzen des Substrats des Flip-Chip-Plättchens, so dass kein Substrat verbleibt, um ein verschwächtes Flip-Chip-Plättchen mit einer freiliegenden Oberfläche am Boden eines Hohlraums bereitzustellen, wobei die freiliegende Oberfläche am Boden des Hohlraums eine Oberfläche einer Ätzstoppschicht ist; und
• Aufbringen (220) einer dritten Formmasse, um den Hohlraum des verschwächten Flip-Chip-Plättchens im Wesentlichen zu füllen, wobei die erste Formmasse und die zweite Formmasse und die dritte Formmasse nicht die gleichen sind, wobei jede verschiedene physikalische Eigenschaften aufweist, wobei die erste Formmasse ein Ferrit-Nanopulver umfasst, um eine magnetische Permeabilität bereitzustellen, die zweite Formmasse ein Füllmittel umfasst, um eine mechanische Festigkeit bereitzustellen, und die dritte Formmasse einen wärmeleitenden Zusatzstoff umfasst, um eine thermische Leitfähigkeit durch die dritte Formmasse bereitzustellen.

8. Verfahren zum Herstellen des Flip-Chip-Moduls nach Anspruch 7, weiterhin umfassend Anordnen (218) einer dielektrischen Schicht über der freiliegenden Oberfläche an der Ätzstoppschicht (44) am Boden des Hohlraums vor Aufbringen der dritten Formmasse.

9. Verfahren zum Herstellen des Flip-Chip-Moduls nach Anspruch 8, wobei die Ätzstoppschicht aus BOX angefertigt wird und die dielektrische Schicht aus SiN angefertigt wird.

10. Verfahren zum Herstellen des Flip-Chip-Moduls nach Anspruch 7, weiterhin umfassend Aufrauen (216) einer oberen Oberfläche der zweiten Formmasse vor Aufbringen der dritten Formmasse.

## Revendications

1. Module à puce retournée comprenant :
• un support (12) ayant une surface supérieure ;
• un premier composé de moulage (40) se trouvant sur la surface supérieure ;
• une première puce retournée amincie (34, 36) sans aucun substrat semi-conducteur et se trouvant au-dessus d'une première partie du premier composé de moulage et ayant un premier ensemble d'interconnexions (18, 20, 24) s'étendant depuis la couche de dispositif (16) et à travers la première partie du premier composé de moulage jusqu'à la surface supérieure, la première partie du premier composé de moulage remplissant une région entre la première puce retournée amincie et la surface supérieure, la première puce retournée amincie fournissant un dispositif passif intégré, IPD, ou un composant microélectromécanique, MEMS ;
• un deuxième composé de moulage (42) se trouvant au-dessus du support et en contact avec le premier composé de moulage et fournissant une première cavité au-dessus de la première puce retournée amincie, la première cavité s'étendant jusqu'à une première surface de puce de la première puce retournée amincie, la première surface de puce étant une couche d'arrêt de gravure ;
• un troisième composé de moulage (48) se trouvant dans la première cavité et recouvrant la couche d'arrêt de gravure de la première puce retournée amincie, le premier composé de moulage et le deuxième composé de moulage et le troisième composé de moulage n'étant pas les mêmes, chacun ayant des propriétés physiques différentes, le premier composé de moulage comportant une nanopoudre de ferrite pour fournir une perméabilité magnétique, le deuxième composé de moulage comportant une charge pour fournir une résistance mécanique, et le troisième composé de moulage comportant un additif thermoconducteur pour fournir une conductance thermique à travers le troisième composé de moulage ; et
• une deuxième puce retournée amincie (34, 36) n'ayant aucun substrat semi-conducteur et se trouvant au-dessus d'une deuxième partie du premier composé de moulage et ayant un deuxième ensemble d'interconnexions s'étendant à travers la deuxième partie jusqu'à la surface supérieure, dans lequel :
• la deuxième partie du premier composé de moulage remplit une région entre la deuxième puce retournée amincie et la surface supérieure ;
• le deuxième composé de moulage fournit une deuxième cavité au-dessus de la deuxième puce retournée de telle sorte que la deuxième cavité s'étend jusqu'à une deuxième surface de puce de la deuxième puce retournée amincie, la deuxième surface de puce étant une deuxième couche d'arrêt de gravure ; et
• le troisième composé de moulage se trouve dans la deuxième cavité et recouvre la deuxième surface de puce de la deuxième puce retournée amincie, et dans lequel la deuxième puce retournée fournit l'autre élément parmi l'IPD et le composant MEMS.

2. Module à puce retournée de la revendication 1 comprenant en outre une puce retournée supplémentaire (38) ayant un substrat semi-conducteur (14), la puce retournée supplémentaire se trouvant au-dessus d'une deuxième partie du premier composé de moulage et ayant un deuxième ensemble d'interconnexions s'étendant à travers la première partie jusqu'à la surface supérieure, dans lequel :
• la deuxième partie du premier composé de moulage remplit une région entre la puce retournée supplémentaire et la surface supérieure ;
• le deuxième composé de moulage recouvre le substrat semi-conducteur de la puce retournée supplémentaire ; et
• le troisième composé de moulage recouvre une surface du deuxième composé de moulage.

3. Module à puce retournée de la revendication 2 dans lequel la première puce retournée amincie est un dispositif MEMS et la puce retournée supplémentaire est un contrôleur à semi-conducteur à oxyde de métal complémentaire, CMOS.

4. Module à puce retournée de la revendication 1 dans lequel le deuxième composé de moulage a une surface configurée pour favoriser l'adhérence avec le troisième composé de moulage.

5. Module à puce retournée de la revendication 1 dans lequel la couche d'arrêt de gravure (44) comprend un oxyde enterré, BOX.

6. Module à puce retournée de la revendication 1 dans lequel le troisième composé de moulage a une conductivité thermique supérieure à 2,5 W/m•K et une résistivité électrique supérieure à 10³ Ω-cm.

7. Procédé de fabrication d'un module à puce retournée comprenant :
• l'obtention d'un support ayant une surface supérieure ;
• la fixation (200) d'une puce retournée à la surface supérieure du support au moyen d'interconnexions (18, 20, 24) qui s'étendent depuis la puce retournée jusqu'à la surface supérieure du support, la première puce retournée fournissant un dispositif passif intégré, IPD, ou un composant microélectromécanique, MEMS ;
• le remplissage (202) d'un espace entre la puce retournée et la surface supérieure du support avec un premier composé de moulage ;
• l'application (206) d'un deuxième composé de moulage sur la surface supérieure du support pour encapsuler la puce retournée ;
• l'amincissement du deuxième composé de moulage pour exposer un substrat de la puce retournée ;
• le retrait par gravure du substrat de la puce retournée de telle sorte qu'il ne reste plus rien du substrat pour obtenir une puce retournée amincie ayant une surface exposée au fond d'une cavité, la surface exposée au fond de la cavité étant une surface d'une couche d'arrêt de gravure ; et
• l'application (220) d'un troisième composé de moulage pour remplir en grande partie la cavité de la puce retournée amincie, dans lequel le premier composé de moulage et le deuxième composé de moulage et le troisième composé de moulage ne sont pas les mêmes, chacun ayant des propriétés physiques différentes, dans lequel le premier composé de moulage comporte une nanopoudre de ferrite pour fournir une perméabilité magnétique, le deuxième composé de moulage comporte une charge pour fournir une résistance mécanique, et le troisième composé de moulage comporte un additif thermoconducteur pour fournir une conductance thermique à travers le troisième composé de moulage.

8. Procédé de fabrication du module à puce retournée de la revendication 7 comportant en outre la mise en place (218) d'une couche diélectrique au-dessus de la surface exposée au niveau de la couche d'arrêt de gravure (44) au fond de la cavité avant l'application du troisième composé de moulage.

9. Procédé de fabrication du module à puce retournée de la revendication 8 dans lequel la couche d'arrêt de gravure est constituée de BOX et la couche diélectrique est constituée de SiN.

10. Procédé de fabrication du module à puce retournée de la revendication 7 comportant en outre la rugosification (216) d'une surface supérieure du deuxième composé de moulage avant l'application du troisième composé de moulage.
